# EUROPEAN PATENT APPLICATION

(11) **EP 3 275 571 A1**
(43) Date of publication of application: **31.01.2018**
(21) Application number: 15886411.6
(22) Date of filing: 26.03.2015
(51) Int. Cl.: B22F 1/00, B22F 1/02, C09C 1/62, C09C 3/06, C09D 5/24, C09D 201/00, C23C 18/42, C25C 5/02, H01B 1/00, H01B 1/22, H01B 5/00

(54) **SILVER-COATED COPPER POWDER AND CONDUCTIVE PASTE, CONDUCTIVE MATERIAL, AND CONDUCTIVE SHEET USING SAME**

(71) Applicant: Sumitomo Metal Mining Co., Ltd., Tokyo 105-8716 (JP)
(72) Inventor: OKADA, Hiroshi, Niihama-shi Ehime 792-0002 (JP); YAMASHITA, Hideyuki, Niihama-shi Ehime 792-0002 (JP)
(74) Representative: Jones, Nicholas Andrew
(86) International application number: PCT/JP2015/059482
(87) International publication number: WO 2016/151859

(57) **Abstract**

Provided is a silver-coated copper powder that has a dendritic shape, that ensures excellent conductivity as a result of having an increased number of points of contact when silver-coated dendritic copper particles are in contact, that prevents aggregation, and that can be suitably used in a conductive paste, an electromagnetic wave shield, or the like. The silver-coated copper powder comprises amassed dendritic copper particles 1 having a linearly grown main trunk 2 and a plurality of branches 3 branching from the main trunk 2. The surface of the copper particles 1 is coated with silver. The main trunk 2 and the branches 3 of the copper particles 1 have a flat plate shape in which the average cross-sectional thickness is more than 1.0 µm but no more than 5.0 µm. The silver-coated copper powder has a flat plate shape configured from a layered structure of one layer or a plurality of stacked layers. The average particle size (D50) is 1.0-100 µm.

## Description

### TECHNICAL FIELD

The present invention relates to a copper powder having the surface coated with silver (silver-coated copper powder), and more specifically, it relates to a novel dendritic silver-coated copper powder which can improve electrical conductivity by being used as a material such as an electrically conductive paste and a copper paste, an electrically conductive coating material, and an electrically conductive sheet using the same.

### BACKGROUND ART

A paste such as a resin type paste or a calcined type paste and a coating material such as an electromagnetic wave shielding coating material which use a metal filler such as a silver powder or a silver-coated copper powder are frequently used in the formation of a wiring layer, an electrode, and the like in an electronic device. A metal filler paste of silver or silver-coated copper is applied or printed on various kinds of substrates and then subjected to a treatment of heat curing or heat calcination to form an electrically conductive film to be a wiring layer or an electrode.

For example, a resin type electrically conductive paste is composed of a metal filler, a resin, a curing agent, a solvent, and the like, and it is formed into an electrically conductive film by being printed on an electric conductor circuit pattern or a terminal and cured by heating at from 100°C to 200°C so as to form a wire and an electrode. In a resin type electrically conductive paste, the thermosetting resin is cured and shrunk by heat, and metal fillers are thus joined by pressure and brought into contact with one another to overlap each other, and as a result, an electrically connected current path is formed. This resin type electrically conductive paste is treated at a curing temperature of 200°C or lower so as to be used in a substrate using a material susceptible to heat such as a printed wiring board.

Meanwhile, a calcination type electrically conductive paste is composed of a metal filler, glass, a solvent, and the like, and it is formed into an electrically conductive film by being printed on an electric conductor circuit pattern or a terminal and calcined by heating at from 600°C to 800°C so as to form a wire and an electrode. The calcination type electrically conductive paste is treated at a high temperature so that the metal fillers are sintered together to secure the conduction. This calcination type electrically conductive paste cannot be used in a printed wiring board using a resin material since it is treated at a high temperature for calcination in this manner, but it is possible to achieve low resistance as the metal fillers are sintered by a high temperature treatment. Hence, a calcination type electrically conductive paste is used in an external electrode of a laminated ceramic capacitor, or the like.

Meanwhile, the electromagnetic wave shield is used to prevent the generation of electromagnetic noises from an electronic device, and particularly in recent years, the housing of a personal computer or a mobile phone is made of a resin, and a method to form a thin metal film by a vapor deposition method or a sputtering method, a method to apply an electrically conductive coating material, and a method to shield electromagnetic waves by attaching an electrically conductive sheet to a required place, and the like have been thus proposed in order to secure the electrical conductivity of the housing. Among them, a method in which a metal filler is dispersed in a resin and applied and a method in which a metal filler is dispersed in a resin and processed into a sheet shape and the sheet is attached to a housing are frequently used as a method exhibiting an excellent degree of freedom since they do not require special equipment in the processing step.

However, in such a case of dispersing a metal filler in a resin and applying the resin or processing the resin into a sheet, the dispersion state of the metal filler in the resin is not uniform, and thus a method for increasing the filling factor of the metal filler or the like is required in order to obtain electromagnetic wave shielding efficiency. However, problems are caused in that the flexibility of the resin sheet is impaired as well as the weight of the sheet increases by the addition of a great amount of metal filler. Hence, for example, in Patent Document 1, it is described that a method using a flat plate-shaped metal filler in order to solve these problems is proposed, and this makes it possible to form a thin sheet exhibiting an excellent electromagnetic wave shielding effect and favorable flexibility.

Here, in order to fabricate such a flat plate-shaped copper powder, for example, Patent Document 2 discloses a method for obtaining a flake-shaped copper powder suitable for a filler of an electrically conductive paste. Specifically, a spherical copper powder having an average particle diameter of from 0.5 µm to 10 µm as a raw material is mechanically processed into a flat plate shape by the mechanical energy of the medium loaded in a mill by using a ball mill or a vibration mill.

In addition, for example, Patent Document 3 discloses a technique related to a copper powder for electrically conductive paste, in particular, a discoid copper powder capable of obtaining high performance as a copper paste for a through hole and an external electrode and a method for producing the same. Specifically, a granular atomized copper powder is put in a medium stirring mill, a fatty acid is added thereto at from 0.5% to 1% by weight with respect to the copper powder, and the copper powder is ground in the air or an inert atmosphere by using a steel ball having a diameter of from 1/8 inch to 1/4 inch as a grinding medium so as to be processed into a flat plate shape.

A silver powder is frequently used as the metal filler to be used in these electrically conductive pastes and electromagnetic wave shields, but there is a tendency to use a silver-coated copper powder obtained by coating the surface of a copper powder that is less expensive than silver powder with silver so as to decrease the amount of silver used due to the cost saving trend.

As a method to coat the surface of a copper powder with silver, there are a method to coat the copper surface with silver by a substitution reaction and a method to coat the copper surface with silver in an electroless plating solution containing a reducing agent.

In the method to coat the copper surface with silver by a substitution reaction, a silver film is formed on the copper surface as the silver ion is reduced by the electrons generated when copper dissolves in the solution. For example, Patent Document 4 discloses a production method in which a silver film is formed on the copper surface by the substitution reaction between copper and the silver ion as a copper powder is put in a solution in which a silver ion is present. However, there is a problem in this substitution reaction method in that the amount of silver coated cannot be controlled since the dissolution of copper does not proceed any more when a silver film is formed on the copper surface.

In order to solve such problem, there is a method to coat silver by electroless plating solution containing a reducing agent. For example, Patent Document 5 proposes a method for producing a copper powder coated with silver by the reaction between a copper powder and silver nitrate in a solution in which a reducing agent is dissolved.

Meanwhile, as the copper powder, an electrolytic copper powder precipitated in a dendritic shape called a dendrite shape is known and it is characterized by a large surface area due to a dendritic shape thereof. There is an advantage that the amount of an electrically conductive filler such as an electrically conductive paste can be decreased since the branches of dendrite overlap each other, conduction is likely to occur, and the number of contact points between particles is greater compared to that of spherical particles in the case of using this in an electrically conductive film or the like since this has a dendritic shape in this manner. For example, Patent Documents 6 and 7 propose a silver-coated copper powder in which the surface of a copper powder having a dendrite shape is coated with silver.

Specifically, Patent Documents 6 and 7 disclose dendrites characterized by long branches branched from the main stem as one that is further grown in a dendrite shape, and it is described that the silver-coated copper powder exhibits improved conduction as the contact points between particles are more than those between the dendrites of the prior art and it can enhance the electrical conductivity when being used in an electrically conductive paste or the like even though the amount of the electrically conductive powder is decreased.

On the other hand, the electrolytic copper powders are intertwined with one another more than the required amount in the case of being used in an electrically conductive paste or the like when dendrites of an electrolytic copper powder are developed, and it is thus pointed out in Patent Document 8 that it is extremely difficult to handle the electrolytic copper powder and the productivity decreases as the aggregation thereof is likely to occur and the fluidity thereof decreases. Incidentally, it is described in Patent Document 8 that it is possible to improve the strength of the electrolytic copper powder itself, to make it difficult for the dendrite to break, and to mold the electrolytic copper powder to have a high strength by adding a tungstate salt to an aqueous solution of copper sulfate that is an electrolytic solution for precipitating the electrolytic copper powder in order to increase the strength of the electrolytic copper powder itself.

In addition, in the case of utilizing a dendritic copper powder as a metal filler of an electrically conductive paste, a resin for electromagnetic wave shielding, or the like, the dendritic copper powders are intertwined with one another to cause aggregation when the metal filler in the resin has a dendritically developed shape, and thus a problem that the dendritic copper powders are not uniformly dispersed in the resin is caused and a problem is caused when wiring is formed by printing as the viscosity of the paste increases by aggregation. Such a problem is also pointed out, for example, in Patent Document 9.

In this manner, it is not easy to use a dendritic copper powder as a metal filler of an electrically conductive paste or the like, and the dendritic copper powder is also a cause of poor progress in the improvement in electrical conductivity of the paste.

In order to secure the electrical conductivity, a dendritic shape having a three-dimensional shape is more likely to secure the contact points than a granular shape and is expected to secure high electrical conductivity as an electrically conductive paste or an electromagnetic wave shield. However, a silver-coated copper powder having a dendrite shape of the prior art is a dendrite characterized by a long branch branched from the main stem and has a long and branched shape so that it has a simple structure from the viewpoint of securing the contact point and does not have an ideal shape as a shape to effectively secure the contact point by using a smaller amount of silver-coated copper powder.
Patent Document 1: Japanese Unexamined Patent Application, Publication No. 2003-258490
Patent Document 2: Japanese Unexamined Patent Application, Publication No. 2005-200734
Patent Document 3: Japanese Unexamined Patent Application, Publication No. 2002-15622
Patent Document 4: Japanese Unexamined Patent Application, Publication No. 2000-248303
Patent Document 5: Japanese Unexamined Patent Application, Publication No. 2006-161081
Patent Document 6: Japanese Unexamined Patent Application, Publication No. 2013-89576
Patent Document 7: Japanese Unexamined Patent Application, Publication No. 2013-100592
Patent Document 8: Japanese Patent No. 4697643
Patent Document 9: Japanese Unexamined Patent Application, Publication No. 2011-58027

### DISCLOSURE OF THE INVENTION

### Problems to be Solved by the Invention

The present invention has been proposed in view of such circumstances, and an object thereof is to provide a dendritic silver-coated copper powder which can be suitably utilized in applications such as an electrically conductive paste and an electromagnetic wave shield by preventing the aggregation thereof while securing excellent electrical conductivity through an increase in the number of contact points when the dendritic copper powders coated with silver come in contact with one another.

### Means for Solving the Problems

The present inventors have carried out intensive investigations to solve the problems described above. As a result, it has been found out that a silver-coated copper powder can be uniformly mixed with, for example, a resin while securing excellent electric conductivity and can be thus suitably used in an application such as an electrically conductive paste as the silver-coated copper powder is constituted as copper particles having a dendritic shape having a dendritically grown main stem and a plurality of branches separated from the main stem and a flat plate shape having a cross sectional average thickness in a particular range gather and has the surface coated with silver and an average particle diameter (D50) is in a particular range, thereby completing the present invention. In other words, the present invention provides the following.
(1) A first aspect of the present invention is a silver-coated copper powder formed as copper particles having a dendritic shape having a linearly grown main stem and a plurality of branches separated from the main stem gather, in which a surface of the silver-coated copper powder is coated with silver, the silver-coated copper powder has a flat plate shape having a cross sectional average thickness of the main stem and the branches of the copper particles of more than 1.0 µm and 5.0 µm or less, the silver-coated copper powder has a flat plate shape constituted by one layer or a layered structure formed of a plurality of overlapping layers and an average particle diameter (D50) is from 1.0 µm to 100 µm.
(2) A second aspect of the present invention is the silver-coated copper powder according to the first aspect, in which a ratio obtained by dividing a cross sectional average thickness of the copper particles coated with silver by an average particle diameter (D50) of the silver-coated copper powder is in a range of more than 0.01 and 5.0 or less.
(3) A third aspect of the present invention is the silver-coated copper powder according to the first or second aspect, in which an amount of silver coated is from 1% by mass to 50% by mass with respect to 100% by mass of the entire silver-coated copper powder coated with silver.
(4) A fourth aspect of the present invention is the silver-coated copper powder according to any one of the first to third aspects, in which a bulk density of the silver-coated copper powder is in a range of from 0.5 g/cm³ to 5.0 g/cm³.
(5) A fifth aspect of the present invention is the silver-coated copper powder according to any one of the first to fourth aspects, in which a BET specific surface area value is from 0.2 m²/g to 3.0 m²/g.
(6) A sixth aspect of the present invention is a metal filler containing the silver-coated copper powder according to any one of the first to fifth aspects at a proportion of 20% by mass or more to the entire metal filler.
(7) A seventh aspect of the present invention is an electrically conductive paste containing the metal filler according to the sixth aspect mixed with a resin.
(8) An eighth aspect of the present invention is an electrically conductive coating material for electromagnetic wave shielding using the metal filler according to the sixth aspect.
(9) A ninth aspect of the present invention is an electrically conductive sheet for electromagnetic wave shielding using the metal filler according to the sixth aspect.

### Effects of the Invention

According to the silver-coated copper powder of the present invention, it is possible to sufficiently secure the contact points when being brought into contact with one another while securing excellent electrical conductivity, to be prevented from being aggregated so as to be uniformly mixed with a resin or the like, and to be thus suitably used in applications such as an electrically conductive paste and an electromagnetic wave shield.

### BRIEF DESCRIPTION OF THE DRAWINGS

Fig. 1 is a diagram which schematically illustrates a specific shape of copper particles which are coated with silver and constitute a dendritic silver-coated copper powder.
Fig. 2 is a photograph which illustrates an observation image when a dendritic copper powder before being coated with silver is observed through a scanning electron microscope at 1,000-times magnification.
Fig. 3 is a photograph which illustrates an observation image when a dendritic copper powder before being coated with silver is observed through a scanning electron microscope at 10,000-times magnification.
Fig. 4 is a photograph which illustrates an observation image when a dendritic copper powder before being coated with silver is observed through a scanning electron microscope at 10,000-times magnification.
Fig. 5 is a photograph which illustrates an observation image when the dendritic silver-coated copper powder is observed through a scanning electron microscope at 1,000-times magnification.
Fig. 6 is a photograph which illustrates an observation image when a dendritic silver-coated copper powder is observed through a scanning electron microscope at 10,000-times magnification.
Fig. 7 is a photograph which illustrates an observation image when the copper powder obtained in Comparative Example 1 is observed through a scanning electron microscope at 5,000-times magnification.
Fig. 8 is a photograph which illustrates an observation image when the copper powder obtained in Comparative Example 2 is observed through a scanning electron microscope at 5,000-times magnification.

### PREFERRED MODE FOR CARRYING OUT THE INVENTION

Hereinafter, specific embodiments (hereinafter, referred to as the "present embodiment") of the copper powder according to the present invention will be described in detail with reference to the drawings. However, the present invention is not limited to the following embodiments, and various modifications are possible without changing the essence of the present invention. Incidentally, the notation "X to Y" (X and Y are arbitrary numerical values) in the present specification means "X or more and Y or less".

### <<1. Dendritic silver-coated copper powder>>

The silver-coated copper powder according to the present embodiment is a silver-coated copper powder which is formed as copper particles having a shape having a dendritically grown main stem and a plurality of branches separated from the main stem gather and has the surface coated with silver.

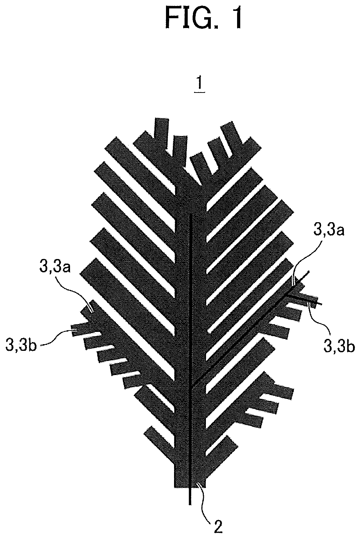

Fig. 1 is a schematic diagram which illustrates a specific shape of the copper particles which are coated with silver and constitute the silver-coated copper powder according to the present embodiment. As illustrated in this schematic diagram of Fig. 1, copper particles 1 coated with silver (hereinafter, simply referred to as the "copper particles 1") have a dendritic shape of a two-dimensional or three-dimensional form. More specifically, the copper particles 1 have a shape having a dendritically grown main stem 2 and a plurality of branches 3 separated from the main stem 2, and the copper particles 1 have a flat plate shape having a cross sectional average thickness of more than 1.0 µm and 5.0 µm or less. Incidentally, the branch 3 in the copper particles 1 means both a branch 3a that is branched from the main stem 2 and a branch 3b that is further branched from the branch 3a.

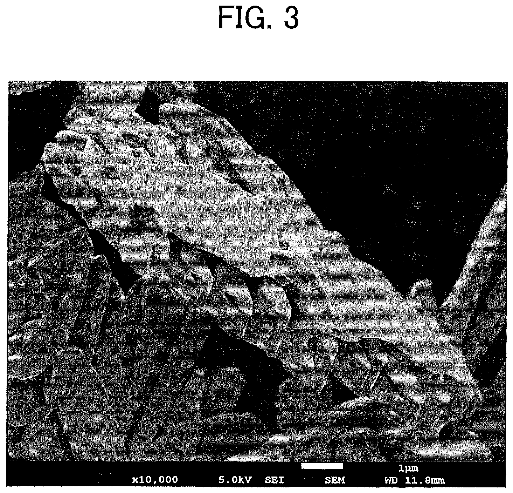

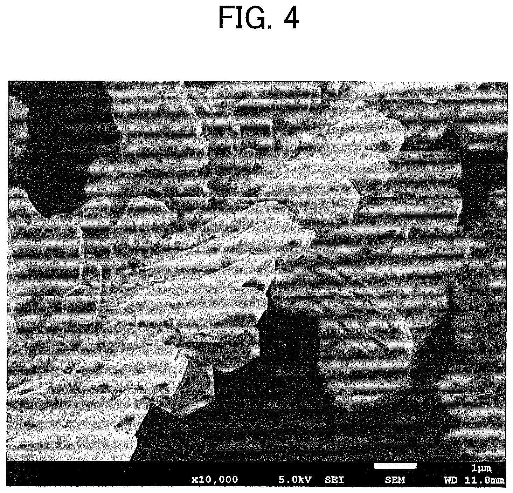

The silver-coated copper powder according to the present embodiment is a silver-coated copper powder (hereinafter, also referred to as the "dendritic silver-coated copper powder") which is constituted as such flat plate-shaped copper particles 1 gather and in which the surface of the copper powder (dendritic copper powder) having a dendritic shape having a main stem and a plurality of branches is coated with silver, and the silver-coated copper powder has a flat plate shape constituted by one layer or a layered structure formed of a plurality of overlapping layers (see the SEM image of the copper powder in Fig. 3 or Fig. 4). Moreover, the average particle diameter (D50) of the dendritic silver-coated copper powder constituted by these flat plate-shaped copper particles 1 is from 1.0 µm to 100 µm.

Incidentally, as to be described later, the amount of silver coated on the dendritic silver-coated copper powder according to the present embodiment is from 1% by mass to 50% by mass with respect to 100% by mass of the entire silver-coated copper powder coated with silver, but the thickness of silver (coated thickness) is an extremely thin film of about 0.15 µm or less. Hence, the dendritic silver-coated copper powder has a shape maintaining the shape of the dendritic copper powder before being coated with silver as it is. Accordingly, the shape of the dendritic copper powder before being coated with silver and the shape of the dendritic silver-coated copper powder after the copper powder is coated with silver are both a dendritic shape of a two-dimensional or three-dimensional form. In addition, the copper powder has a flat plate shape constituted by one layer or a layered structure formed of a plurality of overlapping layers.

Incidentally, the dendritic silver-coated copper powder according to the present embodiment can be obtained, for example, by coating silver on the surface of the dendritic copper powder precipitated on the cathode by immersing an anode and a cathode in an electrolytic solution which exhibits acidity from sulfuric acid and contains a copper ion and allowing a direct current to flow through the electrolytic solution for electrolysis although it will be described in detail later.

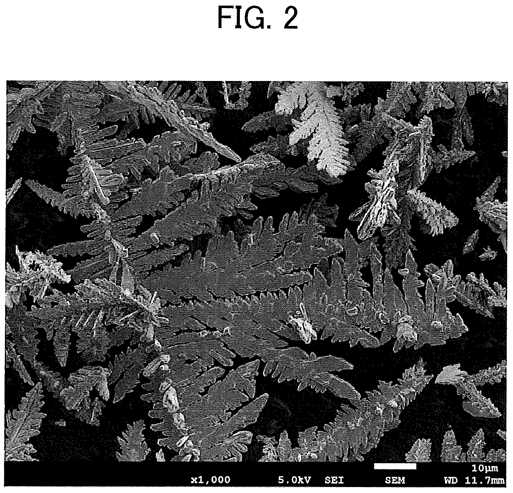

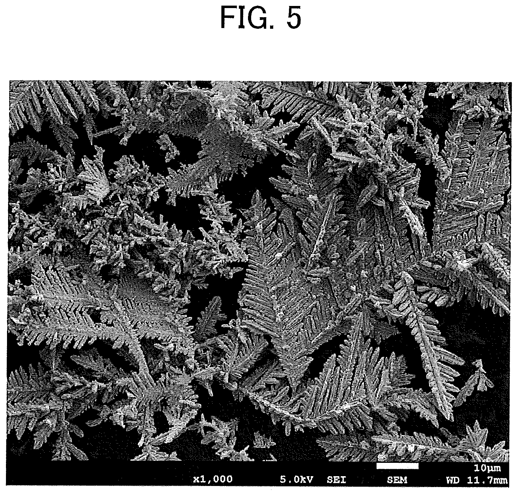

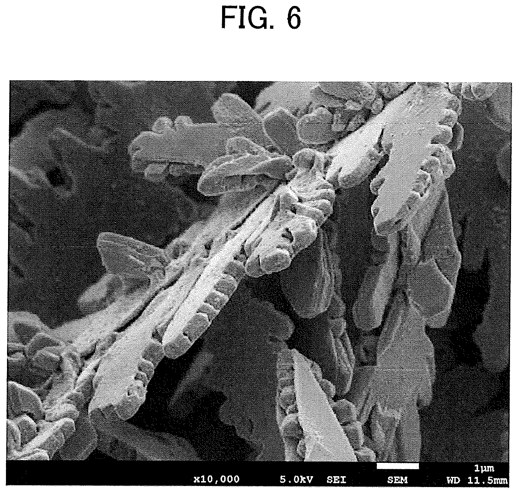

Fig. 2 to Fig. 4 are photographs which illustrate an example of an observation image when the dendritic copper powder before being coated with silver according to the present embodiment is observed through a scanning electron microscope (SEM). Incidentally, Fig. 2 is an image of the dendritic copper powder observed at 5,000-times magnification, and Fig. 3 and Fig. 4 are images of the dendritic copper powder observed at 10,000-times magnification. In addition, Fig. 5 is a photograph which illustrates an example of an observation image when the dendritic silver-coated copper powder obtained by coating the dendritic copper powder of Fig. 2 with silver is observed through an SEM. In addition, Fig. 6 is a photograph which illustrates an example of an observation image when another part of the dendritic silver-coated copper powder obtained by coating the dendritic copper powder with silver is observed through an SEM in the same manner. Incidentally, Fig. 5 is an image of the dendritic silver-coated copper powder observed at 1,000-times magnification, and Fig. 6 is an image of the dendritic silver-coated copper powder observed at 10,000-times magnification.

As illustrated in the observation images of Fig. 2 to Fig. 4, the dendritic copper powder constituting the silver-coated copper powder according to the present embodiment is in a precipitated state having a two-dimensional or three-dimensional dendritic shape having a main stem and branches branched from the main stem. In addition, the main stem and the branches are constituted as the copper particles 1 having a flat plate shape and a dendritic shape (see the schematic diagram of Fig. 1) gather, and the copper particles 1 have a fine convex portion on the surface.

Here, the cross sectional average thickness of the flat plate-shaped copper particles 1 constituting the dendritic copper powder and having the main stem 2 and the branch 3 is more than 1.0 µm and 5.0 µm or less. The effect as a flat plate is further exerted as the cross sectional average thickness of the flat plate-shaped copper particles 1 is thinner. In other words, it is possible to secure a large contact area between the copper particles 1 and between the dendritic silver-coated copper powders constituted by the copper particles as the main stem and the branch of the dendritic copper powder are constituted by flat plate-shaped copper particles 1 having a cross sectional average thickness of 5.0 µm or less, and it is possible to realize low resistance, namely, a high electrical conductivity as the contact area increases. This makes it possible for the dendritic silver-coated copper powder to exhibit superior electrical conductivity, to favorably maintain the electrical conductivity, and to be suitably used in applications of an electrically conductive coating material and an electrically conductive paste. In addition, the dendritic copper powder can contribute to thinning of a wiring material and the like as it is constituted by the flat plate-shaped copper particles 1.

Incidentally, the lower limit of the cross sectional average thickness of the flat plate-shaped copper particles 1 is not particularly limited, but it is possible to obtain the flat plate-shaped copper particles 1 having a cross sectional average thickness of more than 1.0 µm by a method in which the copper particles are precipitated on the cathode from an electrolytic solution which exhibits acidity by sulfuric acid and contains a copper ion to be described later by electrolysis.

In addition, the average particle diameter (D50) of the dendritic silver-coated copper powder according to the present embodiment is from 1.0 µm to 100 µm. Incidentally, the average particle diameter (D50) can be measured, for example, by a laser diffraction method and scattering type particle size distribution measurement.

For example, as pointed out in Patent Document 1, a problem of a dendritic silver-coated copper powder is that the dendritic copper powders are intertwined with one another to cause aggregation and are not uniformly dispersed in the resin in some cases when the metal filler in the resin has a developed dendritic shape in the case of utilizing the dendritic copper powder as a metal filler of an electrically conductive paste, a resin for electromagnetic wave shield, or the like. In addition, the viscosity of the paste increases due to the aggregation so as to cause a problem in wiring formation by printing. This is caused by a large shape of the dendritic silver-coated copper powder (particle diameter), and the size of the shape of the dendritic silver-coated copper powder is required to be decreased in order to solve this problem while taking advantage of the dendritic shape. However, it is impossible to secure the dendritic shape when the particle diameter of the dendritic silver-coated copper powder is too small. Hence, the dendritic silver-coated copper powder is required to have a size larger than a predetermined size in order to secure the effect of being a dendritic shape, namely, the effect that the dendritic copper powder has a large surface area, exhibits excellent moldability and sinterability, and can be molded to have a high strength by being strongly connected to one another via a branch-shaped place as it has a three-dimensional shape.

In this regard, the surface area increases and favorable moldability and sinterability can be secured as the average particle diameter of the dendritic silver-coated copper powder according to the present embodiment is from 1.0 µm to 100 µm. Moreover, this dendritic silver-coated copper powder has a dendritic shape as well as is constituted as the copper particles 1 having a dendritic shape having the main stem 2 and the branches 3 and a flat plate shape gather, and it is thus possible to secure more contact points between the dendritic silver-coated copper powders by the three-dimensional effect of being in a dendritic shape and the effect that the copper particles 1 constituting the dendritic shape have a flat plate shape.

Here, as described in Patent Document 2 and Patent Document 3, for example, in a case in which a spherical copper powder is formed into a flat plate shape by a mechanical method, the spherical copper powder is processed into a flat plate shape by adding a fatty acid and grinding the spherical copper powder in the air or an inert atmosphere since it is required to prevent the oxidation of copper at the time of mechanical processing. However, it is required to remove the fatty acid after completion of the processing since it is impossible to completely prevent oxidation and the fatty acid added at the time of processing affects the dispersibility when the copper powder is formed into a paste in some cases, but the fatty acid is firmly attached to the copper surface by the pressure at the time of mechanical processing in some cases and a problem arises that the fatty acid cannot be completely removed.

On the contrary, the flat plate-shaped copper particles 1 constituting the dendritic silver-coated copper powder according to the present embodiment are fabricated by directly growing the copper particles into the shape of dendritic copper powder without conducting mechanical processing, and thus oxidation to be a problem in the mechanical processing does not occur, the removal of fatty acid is not required, and the electrical conductivity can be in a significantly favorable state.

In addition, the dendritic silver-coated copper powder according to the present embodiment is not particularly limited, but it is preferable that the ratio (cross sectional average thickness/average particle diameter) obtained by dividing the cross sectional average thickness of the flat plate-shaped copper particles 1 by the average particle diameter (D50) of the silver-coated copper powder described above is in a range of more than 0.01 and 0.5 or less.

Here, the ratio (aspect ratio) represented by "cross sectional average thickness/average particle diameter" is an indicator, for example, of aggregation degree and dispersibility when the dendritic silver-coated copper powder 1 is processed as an electrically conductive copper paste and of the retainability of the appearance of the shape at the time of coating the copper paste. When this aspect ratio exceeds 5.0, the dendritic silver-coated copper powder is close to a copper powder composed of spherical copper particles, and the effect by face contact points is not exerted. On the other hand, when the aspect ratio is 0.01 or less, the viscosity increases at the time of forming the dendritic silver-coated copper powder 1 into a paste and the retainability of the appearance of the shape and the surface smoothness of the copper paste at the time of being applied deteriorate in some cases.

In addition, the bulk density of the dendritic silver-coated copper powder according to the present embodiment is not particularly limited, but it is preferably in a range of from 0.5 g/cm³ to 5.0 g/cm³. There is a possibility that the contact points among the silver-coated copper powders cannot be sufficiently secured when the bulk density is less than 0.5 g/cm³. On the other hand, when the bulk density exceeds 5.0 g/cm³, the average particle diameter of the silver-coated copper powder also increases, the surface area decreases, and the moldability and the sinterability thus deteriorate in some cases.

Incidentally, it is possible to obtain the same effect as the silver-coated copper powder composed only of the dendritic silver-coated copper powder when the dendritic silver-coated copper powder having the shape as described above accounts for a predetermined proportion in the obtained silver-coated copper powder when observed through an electron microscope although copper powders having shapes other than the shape are mixed therein. Specifically, silver-coated copper powders having shapes other than the shape described above may be contained in the obtained copper powder as long as the dendritic silver-coated copper powder having the shape described above accounts for 80% by number or more, and preferably 90% by number or more in the entire silver-coated copper powders when observed through an electron microscope (for example, 500-times to 20,000-times).

### <<2. Amount of silver coated>>

As described above, the dendritic silver-coated copper powder 1 according to the present embodiment is constituted in a dendritic shape by copper particles 1 which have a flat plate shape having a cross sectional average thickness of more than 1.0 µm to 5.0 µm or less and the surface of which is coated with silver. Hereinafter, coating of the surface of the silver-coated copper powder with silver will be described.

In the dendritic silver-coated copper powder according to the present embodiment, the dendritic copper powder before being coated with silver is preferably coated with silver at a proportion of from 1% by mass to 50% by mass with respect to 100% by mass of the entire silver-coated copper powder coated with silver, and the thickness (coated thickness) of silver is an extremely thin film of 0.15 µm or less. By this fact, the dendritic silver-coated copper powder has a shape maintaining the shape of the dendritic copper powder before being coated with silver as it is.

The amount of silver coated on the dendritic silver-coated copper powder is preferably in a range of from 1% by mass to 50% by mass with respect to 100% by mass of the entire silver-coated copper powder coated with silver. It is preferable that the amount of silver coated is as small as possible from the viewpoint of cost, but it is impossible to secure a uniform silver film on the surface of the copper powder and a decrease in electrical conductivity is thus caused when the amount is too small. Hence, the amount of silver coated is preferably 1% by mass or more, more preferably 5% by mass or more, and even more preferably 10% by mass or more with respect to 100% by mass of the entire silver-coated copper powder coated with silver.

On the other hand, it is not preferable that the amount of silver coated is too great from the viewpoint of cost, and the amount of silver coated is preferably 50% by mass or less, more preferably 30% by mass or less, and even more preferably 20% by mass or less with respect to 100% by mass of the entire silver-coated copper powder coated with silver.

In addition, in the dendritic silver-coated copper powder according to the present embodiment, the average thickness of silver coated on the surface of the dendritic copper powder is about from 0.003 µm to 0.15 µm and preferably from 0.005 µm to 0.05 µm. It is impossible to secure uniform silver coating on the surface of the copper powder and a decrease in electrical conductivity is caused when the thickness of silver coated is less than 0.0003 µm on average. On the other hand, it is not preferable that the thickness of silver coated exceeds 0.15 µm on average from the viewpoint of cost.

As described above, the average thickness of silver coated on the surface of the dendritic copper powder is about from 0.0003 µm to 0.15 µm to be thin as compared to the cross sectional average thickness (from 0.5 µm to 5.0 µm) of flat plate-shaped copper particles 1 constituting the dendritic copper powder. Hence, the cross sectional average thickness of the flat plate-shaped copper particles 1 does not substantially change before and after the surface of the dendritic copper powder is coated with silver.

In addition, the value of the BET specific surface area of the dendritic silver-coated copper powder according to the present embodiment is preferably from 0.2 m²/g to 3.0 m²/g although it is not particularly limited. The copper particles coated with silver 1 do not have the desired shape as described above and high electrical conductivity is not obtained in some cases when the BET specific surface area value is less than 0.2 m²/g. On the other hand, when the BET specific surface area value exceeds 3.0 m²/g, there is a possibility that the coating of the surface of the dendritic silver-coated copper powder with silver is not uniform and high electrical conductivity is not obtained. In addition, the copper particles 1 constituting the silver-coated copper powder are too fine and the silver-coated copper powder is in a fine whisker-shaped state so that the electrical conductivity decreases in some cases. Incidentally, the BET specific surface area can be measured in conformity with JIS Z 8830: 2013.

### <<3. Production method of silver-coated copper powder>>

Next, a method for producing the dendritic silver-coated copper powder according to the present embodiment will be described. Hereinafter, a method for producing the dendritic copper powder constituting the dendritic silver-coated copper powder will be described first, and a method for obtaining a dendritic silver-coated copper powder by coating the dendritic copper powder with silver will be subsequently described.

### <3-1. Production method of dendritic copper powder>

The dendritic copper powder before being coated with silver can be produced by a predetermined electrolytic method using, for example, a solution which exhibits acidity from sulfuric acid and contains a copper ion as an electrolytic solution.

Upon electrolysis, for example, the solution which exhibits acidity by sulfuric acid and contains a copper ion is accommodated in an electrolytic cell in which metallic copper is installed as the anode and a stainless steel plate, a titanium plate, or the like is installed as the cathode and an electrolytic treatment is conducted by applying a direct current to the electrolytic solution at a predetermined current density. This makes it possible to precipitate (electrodeposit) the dendritic copper powder on the cathode along with energization. Particularly, in the present embodiment, it is possible to precipitate the dendritic copper powder in which the flat plate-shaped copper particles 1 gather to form a dendritic shape on the surface of the cathode by only the electrolysis without subjecting the copper powder which is obtained by electrolysis and has a granular shape or the like to mechanical deformation processing or the like using a medium such as a ball.

More specifically, as the electrolytic solution, for example, one that contains a water-soluble copper salt, sulfuric acid, an additive such as an amine compound, and a chloride ion can be used.

The water-soluble copper salt is a copper ion source for supplying a copper ion, and examples thereof may include copper sulfate such as copper sulfate pentahydrate, copper chloride, and copper nitrate, but the water-soluble copper salt is not limited thereto. In addition, the concentration of the copper ion in the electrolytic solution can be set to about from 1 g/L to 20 g/L and preferably about from 2 g/L to 10 g/L.

Sulfuric acid is an acid that is used to prepare an electrolytic solution exhibiting acidity from sulfuric acid. The concentration of sulfuric acid in the electrolytic solution may be set to about from 20 g/L to 300 g/L and preferably about from 50 g/L to 200 g/L as the concentration of free sulfuric acid. This concentration of sulfuric acid affects the electrical conductivity of the electrolytic solution and it thus affects the uniformity of the copper powder obtained on the cathode.

As an additive, for example, an amine compound can be used. This amine compound contributes to the shape control of the copper powder to be precipitated together with the chloride ion to be described later, and it is thus possible to form the copper powder to be precipitated on the surface of the cathode into a dendritic copper powder having a main stem and branches which are constituted by flat plate-shaped copper particles having a dendritic shape and a predetermined cross sectional average thickness.

As the amine compound, for example, Safranin 0 (3,7-diamino-2,8-dimethyl-5-phenyl-5-phenazinium chloride, C₂₀H₁₉N₄Cl, CAS No. 477-73-64) and the like can be used. Incidentally, as the amine compound, one kind may be added singly or two or more kinds may be added concurrently. In addition, the amount of the amine compound added is set to an amount so that the concentration of the amine compound in the electrolytic solution is preferably in a range of more than 50 mg/L and 500 mg/L or less and more preferably in a range of from 100 mg/L to 400 mg/L.

The chloride ion can be contained in the electrolytic solution by adding a compound (chloride ion source) for supplying a chloride ion such as hydrochloric acid or sodium chloride thereto. The chloride ion contributes to the shape control of the copper powder to be precipitated together with the additive such as the amine compound described above. The concentration of the chloride ion in the electrolytic solution can be set to about from 1 mg/L to 1000 mg/L, preferably about from 10 mg/L to 500 mg/L although it is not particularly limited.

In the method for producing the dendritic copper powder, for example, the dendritic copper powder is produced by precipitating and generating a copper powder on the cathode through electrolysis using the electrolytic solution having the composition as described above. A known method can be used as the electrolysis method. For example, the current density is preferably set to a range of from 5 A/dm² to 30 A/dm² upon electrolysis using an electrolytic solution exhibiting acidity by sulfuric acid, and the electrolytic solution is energized while being stirred. In addition, the liquid temperature (bath temperature) of the electrolytic solution can be set, for example, to about from 20°C to 60°C.

### <3-2. Coating method of silver (production of silver-coated copper powder)>

The dendritic silver-coated copper powder according to the present embodiment can be produced, for example, by coating the surface of the dendritic copper powder fabricated by the electrolysis method described above with silver by using a reduction type electroless plating method or substitution type electroless plating method.

It is preferable to conduct washing before silver plating in order to coat the surface of the dendritic copper powder with silver in a uniform thickness, and it is preferable to conduct washing while dispersing and stirring the dendritic copper powder in the washing liquid. This washing treatment is preferably conducted in an acidic solution, and it is more preferable to use a polycarboxylic acid, which is also used as a reducing agent to be described later. After washing, filtration, separation, and water washing of the dendritic copper powder are appropriately repeated to obtain a water slurry in which the dendritic copper powder is dispersed in water. Incidentally, known methods may be used for the filtration, separation, and water washing.

Specifically, in the case of conducting silver coating by the reduction type electroless plating method, it is possible to coat the surface of the dendritic copper powder with silver by adding a reducing agent and a silver ion solution to the water slurry obtained after washing the dendritic copper powder. Here, it is possible to more uniformly coat the surface of the dendritic copper powder with silver by adding and dispersing the reducing agent in the water slurry in advance and then continuously adding the silver ion solution to the water slurry containing the reducing agent and the dendritic copper powder.

Various reducing agents can be used as the reducing agent, but the reducing agent is preferably a reducing agent having a weak reducing power that cannot reduce a complex ion of copper. As the weak reducing agent, a reducing organic compound can be used, and for example, a carbohydrate, a polycarboxylic acid and a salt thereof, an aldehyde, and the like can be used. More specific examples thereof may include grape sugar (glucose), lactic acid, oxalic acid, tartaric acid, malic acid, malonic acid, glycolic acid, sodium potassium tartrate, and formalin.

After the reducing agent is added to the water slurry containing the dendritic copper powder, it is preferable to conduct stirring or the like in order to sufficiently disperse the reducing agent. In addition, it is possible to appropriately add an acid or an alkali in order to adjust the water slurry to a desired pH. Furthermore, the dispersion of the reducing organic compound of a reducing agent may be accelerated by adding a water-soluble organic solvent such as an alcohol.

As the silver ion solution to be continuously added, those known as a silver plating solution can be used, but among them, it is preferable to use a silver nitrate solution. In addition, the silver nitrate solution is more preferably added as an ammoniacal silver nitrate solution since it easily forms a complex. Incidentally, ammonia to be used for the ammoniacal silver nitrate solution may be added to the silver nitrate solution, added to the water slurry together with the reducing agent in advance and dispersed, or simultaneously added to the water slurry as an ammonia solution different from the silver nitrate solution, or any method including a combination of these may be used.

It is preferable to gradually add the silver ion solution at a relatively slow rate upon adding the silver ion solution to the water slurry containing, for example, the dendritic copper powder and the reducing agent, and this makes it possible to form a silver film having a uniform thickness on the surface of the dendritic copper powder. In addition, it is more preferable to keep the addition rate constant in order to increase the uniformity of the film thickness. Furthermore, the reducing agent and the like that are added to the water slurry in advance may be adjusted with another solution and gradually optionally added together with the silver ion solution.

In this manner, a dendritic silver-coated copper powder can be obtained by filtering, separating, washing with water, and then drying the water slurry to which the silver ion solution and the like are added. The methods for these treatments from the filtration are not particularly limited, and known methods may be used.

Meanwhile, the method to coat silver by the substitution type electroless plating method utilizes the difference in ionization tendency between copper and silver, and the silver ions in the solution are reduced by the electrons generated when the copper dissolves in the solution and silver thus obtained is precipitated on the copper surface in the method. Accordingly, it is possible to coat silver when the substitution type electroless silver plating solution is constituted by a silver salt as a silver ion source, a complexing agent, and a conductive salt as main components, but it is possible to add a surfactant, a brightener, a crystal modifier, a pH adjuster, a precipitation inhibitor, a stabilizer, and the like to the plating solution if necessary in order to more uniformly coat silver. The plating solution is not particularly limited in the production of the silver-coated copper powder according to the present embodiment as well.

More specifically, it is possible to use silver nitrate, silver iodide, silver sulfate, silver formate, silver acetate, silver lactate, and the like as the silver salt, and it is possible to react the silver salt with the dendritic copper powder dispersed in the water slurry. The concentration of silver ion in the plating solution can be set to about from 1 g/L to 10 g/L.

In addition, the complexing agent forms a complex with the silver ion, as a typical complexing agent, it is possible to use citric acid, tartaric acid, ethylenediaminetetraacetic acid, nitrilotriacetic acid, and the like or an N-containing compound such as ethylenediamine, glycine, hydantoin, pyrrolidone, or succinimide, hydroxyethylidene diphosphonic acid, aminotrimethylene phosphonic acid, mercaptopropionic acid, thioglycol, thiosemicarbazide, and the like. The concentration of the complexing agent in the plating solution can be set to about from 10 g/L to 100 g/L.

In addition, as the conductive salt, it is possible to use an inorganic acid such as nitric acid, boric acid, or phosphoric acid, an organic acid such as citric acid, maleic acid, tartaric acid, or phthalic acid, or sodium, potassium, and ammonium salts thereof, and the like. The concentration of the conductive salt in the plating solution can be set to about from 5 g/L to 50 g/L.

The coating amount when silver is coated on the surface of the dendritic copper powder can be controlled, for example, by changing the amount of silver input in the substitution type electroless plating solution. In addition, it is preferable to keep the addition rate constant in order to enhance the uniformity of the film thickness.

In this manner, a dendritic silver-coated copper powder can be obtained by filtering, separating, washing with water, and then drying the slurry of which the reaction has been completed. The methods for these treatments from the filtration are not particularly limited, and known methods may be used.

### <<4. Application of electrically conductive paste, electrically conductive coating material for electromagnetic wave shielding, and electrically conductive sheet>>

As described above, the dendritic silver-coated copper powder according to the present embodiment is a dendritic silver-coated copper powder having a main stem and a plurality of branches branched from the main stem and is constituted as copper particles which have a shape having the dendritically grown main stem 2 and a plurality of branches 3 separated from the main stem 2 and a flat plate shape having a cross sectional average thickness of more than 1.0 µm and 5.0 µm or less and are coated with silver gather as illustrated in the schematic diagram of Fig. 1. Moreover, the average particle diameter (D50) of the dendritic silver-coated copper powder is from 1.0 µm to 100 µm. Such a dendritic silver-coated copper powder has a large surface area and exhibits excellent moldability and sinterability by being in a dendritic shape, and the dendritic silver-coated copper powder can secure a large number of contact points and exerts excellent electric conductivity by being constituted in a dendritic shape as the flat plate-shaped copper particles having a predetermined cross sectional average thickness gather.

In addition, according to the dendritic silver-coated copper powder having such a predetermined structure, it is possible to suppress aggregation of the dendritic silver-coated copper powder and to uniformly disperse dendritic silver-coated copper powder in the resin even in the case of forming dendritic silver-coated copper powder into a copper paste or the like, and it is also possible to suppress occurrence of defective printing and the like due to an increase in viscosity of the paste or the like. Accordingly, dendritic silver-coated copper powder can be suitably used in applications such as an electrically conductive paste and an electrically conductive coating material.

For example, as an electrically conductive paste (copper paste), the dendritic silver-coated copper powder according to the present embodiment is not limited to use under particularly limited conditions, but the electrically conductive paste can be fabricated by kneading the dendritic silver-coated copper powder as a metal filler with a binder resin and a solvent and further with an additive such as an antioxidant or a coupling agent if necessary.

Specifically, the binder resin is not particularly limited, and those that have been used in the prior art can be used. For example, an epoxy resin, a phenol resin, an unsaturated polyester resin, or the like can be used.

In addition, with regard to the solvent as well, it is possible to use an organic solvent such as ethylene glycol, diethylene glycol, triethylene glycol, glycerin, terpineol, ethyl carbitol, carbitol acetate, and butyl cellosolve, which have been used in the prior art. In addition, the amount of the organic solvent added is not particularly limited, but the added amount can be adjusted in consideration of the particle size of the dendritic silver-coated copper powder so as to obtain a viscosity suitable for an electrically conductive film forming method such as screen printing or a dispenser. Furthermore, it is also possible to add another resin component for adjustment of viscosity. Examples thereof may include a cellulose-based resin typified by ethyl cellulose, and the resin component can be added as an organic vehicle by being dissolved in an organic solvent such as terpineol. Incidentally, the amount of the resin component added is required to be suppressed to an extent to which the sinterability is not inhibited, and it is preferably set to 5% by weight or less with respect to the total amount.

In addition, for example, an antioxidant can be added as an additive for improving electrical conductivity after calcination. The antioxidant is not particularly limited, but examples thereof may include a hydroxycarboxylic acid. More specifically, a hydroxycarboxylic acid such as citric acid, malic acid, tartaric acid, or lactic acid is preferable, and citric acid or malic acid having a high adsorptive power to copper is even more preferable. The amount of the antioxidant added can be set, for example, to about from 1% by weight to 15% by weight in consideration of the antioxidation effect, the viscosity of the paste, and the like.

In addition, as the curing agent as well, 2-ethyl-4-methylimidazole and the like which have been used in the prior art can be used. Furthermore, as the corrosion inhibitor as well, benzothiazole, benzimidazole, and the like which have been used in the prior art can be used.

In addition, the dendritic silver-coated copper powder according to the present embodiment can be used by being mixed with a copper powder having another shape, a silver-coated copper powder, and a metal filler such as nickel or tin having electrical conductivity in the case of being utilized as a metal filler for electrically conductive paste. At this time, the proportion of the dendritic silver-coated copper powder in the total amount of the metal fillers used as an electrically conductive paste is preferably 20% by mass or more, more preferably 30% by mass or more, and even more preferably 40% by mass or more. In this manner, in the case of using the dendritic silver-coated copper powder as a metal filler, the gap of the dendritic silver-coated copper powder is filled with a copper powder having another shape by mixing a metal filler such as the copper powder having another shape together with the dendritic silver-coated copper powder according to the present embodiment, and this makes it possible to secure more contact points for securing electrical conductivity. In addition, as a result, it is also possible to decrease the total input amount of the dendritic silver-coated copper powder and a copper powder having another shape.

When the dendritic silver-coated copper powder is less than 20% by mass in the total amount of the copper powders to be used as the metal filler, the contact points among the dendritic silver-coated copper powders decrease and electrical conductivity as a metal filler decreases even if an increase in the number of contact points due to mixing of the dendritic silver-coated copper powder with a copper powder having another shape is taken into consideration.

It is possible to form various kinds of electric circuits by using the electrically conductive paste fabricated by utilizing the metal filler described above. In this case as well, it is not used under particularly limited conditions, but it is possible to utilize a circuit pattern forming method or the like which has been conducted in the prior art. For example, it is possible to form a printed wiring board, an electric circuit of various kinds of electronic parts, an external electrode, and the like by applying or printing the electrically conductive paste fabricated by utilizing the metal filler described above on a calcined substrate or a non-calcined substrate, heating, then pressing if necessary, curing, and baking it.

In addition, in the case of utilizing the metal filler described above as the material for electromagnetic wave shielding as well, the metal filler is not used under particularly limited conditions but can be used by a general method, for example, by being mixed with a resin.

For example, in the case of forming an electrically conductive coating material for electromagnetic wave shielding by utilizing the metal filler described above, the metal filler can be used as an electrically conductive coating material by a general method, for example, by being mixed with a resin and a solvent and further with an antioxidant, a thickener, an anti-settling agent, and the like if necessary and kneaded together.

The binder resin and solvent to be used at this time are not particularly limited, and those that have been used in the prior art can be used. For example, a vinyl chloride resin, a vinyl acetate resin, an acrylic resin, a polyester resin, a fluorocarbon resin, a silicone resin, a phenol resin, and the like can be used as the binder resin. In addition, with regard to the solvent as well, it is possible to use an alcohol such as isopropanol, an aromatic hydrocarbon such as toluene, an ester such as methyl acetate, a ketone such as methyl ethyl ketone, and the like which have been used in the prior art. In addition, with regard to the antioxidant as well, it is possible to use a fatty acid amide, a higher fatty acid amine, a phenylenediamine derivative, a titanate-based coupling agent, and the like, which have been used in the prior art.

In addition, in the case of forming an electrically conductive sheet for electromagnetic wave shielding by utilizing the metal filler described above as well, the resin to be used for forming the electromagnetic wave shielding layer of the electrically conductive sheet for electromagnetic wave shielding is not particularly limited, and those that have been used in the prior art can be used. For example, it is possible to appropriately use a thermoplastic resin, a thermosetting resin, a radiation-curing resin, and the like that are composed of various kinds of polymers and copolymers such as a vinyl chloride resin, a vinyl acetate resin, a vinylidene chloride resin, an acrylic resin, a polyurethane resin, a polyester resin, an olefin resin, a chlorinated olefin resin, a polyvinyl alcohol-based resin, an alkyd resin, and a phenol resin.

The method for producing the electromagnetic wave shielding material is not particularly limited, but for example, the electromagnetic wave shielding material can be produced by applying or printing a coating material in which a metal filler and a resin are dispersed or dissolved in a solvent on a substrate to form an electromagnetic wave shielding layer and drying the coating material to an extent to which the surface is solidified. In addition, it is possible to utilize a metal filler containing the dendritic silver-coated copper powder according to the present embodiment in the electrically conductive adhesive layer of an electrically conductive sheet.

### EXAMPLES

Hereinafter, the present invention will be described more specifically with reference to Examples together with Comparative Examples, but the present invention is not limited to the following Examples at all.

### <<Evaluation method>>

The observation of shape, the measurement of average particle diameter, and the like were carried out on the silver-coated copper powders obtained in Examples and Comparative Examples by the following methods.

### (Observation of shape)

Arbitrary 20 fields of vision were observed in a field of vision at predetermined magnification through a scanning electron microscope (model: JSM-7100F manufactured by JEOL Ltd.), and the appearance of the copper powder contained in the field of vision was observed.

### (Measurement of average particle diameter)

The average particle diameter (D50) was measured by using a laser diffraction/scattering method particle size distribution measuring instrument (HRA9320 X-100 manufactured by NIKKISO CO., LTD.).

### (Measurement of aspect ratio)

The obtained silver-coated copper powder was embedded in an epoxy resin to fabricate a sample for measurement, and the sample was cut, polished, and observed through a scanning electron microscope to observe the cross section of the silver-coated copper powder. More specifically, 20 copper powders were observed and the average thickness (cross sectional average thickness) of the copper powders was determined, and the aspect ratio (cross sectional average thickness/D50) was determined from the ratio of the cross sectional average thickness value to the average particle diameter (D50) determined by using a particle size distribution measuring instrument using a laser diffraction/scattering method.

### (BET specific surface area)

The BET specific surface area was measured by using a specific surface area and pore distribution measuring instrument (QUADRASORB SI manufactured by Quantachrome Instruments).

### (Measurement of specific resistance value)

The specific resistance value of the coating film was determined by measuring the sheet resistance value with a four-terminal method using a low resistivity meter (Loresta-GP MCP-T600 manufactured by Mitsubishi Chemical Corporation) and the film thickness of the coating film using a surface roughness and shape measuring instrument (SURFCO M130A manufactured by TOKYO SEIMITSU CO., LTD.) and dividing the sheet resistance value by the film thickness.

### (Electromagnetic wave shielding property)

The evaluation of the electromagnetic wave shielding property was carried out by measuring the attenuation factor of the samples obtained in the respective Examples and Comparative Examples by using an electromagnetic wave having a frequency of 1 GHz. Specifically, the level in the case of Comparative Example 4 in which the dendritic silver-coated copper powder was not used was evaluated as "Δ", a case in which the attenuation factor was worse than the level of Comparative Example 4 was evaluated as "×", a case in which the attenuation factor was more favorable than the level of Comparative Example 4 was evaluated as "○", and a case in which the attenuation factor was superior to the level of Comparative Example 4 was evaluated as "⊙".

In addition, it was confirmed whether the electromagnetic wave shielding property changed or not by bending the fabricated electromagnetic wave shield in order to evaluate the flexibility of the electromagnetic wave shield.

### <<Examples and Comparative Examples>>

### [Example 1]

### <Production of dendritic copper powder>

A titanium electrode plate having an electrode area of 200 mm × 200 mm and a copper electrode plate having an electrode area of 200 mm × 200 mm were installed in an electrolytic cell having a capacity of 100 L as the cathode and the anode, respectively, an electrolytic solution was put in the electrolytic cell, and a direct current was applied to this, thereby precipitating a copper powder (dendritic copper powder) on the cathode plate.

At this time, a solution having a composition in which the concentration of copper ion was 5 g/L and the concentration of sulfuric acid was 150 g/L was used as the electrolytic solution. In addition, Safranin 0 (safranin, manufactured by KANTO CHEMICAL CO., INC.) as an additive was added to this electrolytic solution so as to have a concentration of 100 mg/L in the electrolytic solution, and a hydrochloric acid solution (manufactured by Wako Pure Chemical Industries, Ltd.) was further added thereto so that the concentration of chloride ion (chlorine ion) in the electrolytic solution was 10 mg/L. Thereafter, an electric current was applied to the electrolytic solution having a concentration adjusted as described above so that the current density of the cathode was 25 A/dm² under a condition in which the electrolytic solution was circulated at a flow rate of 15 L/min by using a pump and the temperature thereof was maintained at 25°C, thereby precipitating a copper powder on the cathode plate. The electrolytic copper powder precipitated on the cathode plate was mechanically scraped off to the cell bottom of the electrolytic cell by using a scraper and recovered, and the copper powder thus recovered was washed with pure water, then placed in a vacuum dryer, and dried.

The shape of the electrolytic copper powder thus obtained was observed by the method using a scanning electron microscope (SEM) described above, and as a result, at least 90% by number or more of copper powders in the copper powders thus precipitated was a dendritic copper powder which was formed as copper particles having a shape having a linearly grown main stem, a plurality of branches linearly branched from the main stem, and branches further branched from the branches gather and had a two-dimensional or three-dimensional dendritic shape. In addition, the copper powder had a flat plate shape constituted by one layer or a layered structure formed of a plurality of overlapping layers.

### <Production of dendritic silver-coated copper powder by reduction method>

Next, a silver-coated copper powder was fabricated by using the dendritic copper powder fabricated by the method described above.

In other words, 100 g of the dendritic copper powder thus obtained was stirred in a 3% aqueous solution of tartaric acid for about 1 hour, then filtered, washed with water, and dispersed in 2 liters of ion exchanged water. To this, 5 g of tartaric acid, 5 g of glucose, and 50 ml of ethanol were added, 50 ml of 28% ammonia water was further added thereto and stirred, thereafter, an aqueous solution prepared by dissolving 60 g of silver nitrate in 4 liters of ion exchanged water, an aqueous solution prepared by dissolving 25 g of glucose, 25 g of tartaric acid, and 250 ml of ethanol in 750 ml of ion exchanged water, and 250 ml of 28% ammonia water were gradually added to the mixture over 60 minutes, respectively. The bath temperature at this time was 25°C.

After the addition of each aqueous solution was completed, the powder was filtered, washed with water, and dried over ethanol, thereby obtaining a dendritic silver-coated copper powder in which the surface of the dendritic copper powder was coated with silver. In addition, the dendritic silver-coated copper powder had a flat plate shape constituted by one layer or a layered structure formed of a plurality of overlapping layers. The dendritic silver-coated copper powder was recovered, and the amount of silver coated was measured to have a result of 26.2% by mass with respect to 100% by mass of the entire silver-coated copper powder coated with silver. In addition, the dendritic silver-coated copper powder thus obtained was observed through an SEM in a field of vision at 5,000-times magnification, and as a result, the dendritic silver-coated copper powder was a dendritic silver-coated copper powder having a two-dimensional or three-dimensional dendritic shape in which the surface of the dendritic copper powder before being coated with silver was uniformly coated with silver and it was a dendritic silver-coated copper powder having a dendritic shape having a dendritically grown main stem, a plurality of branches branched from the main stem, and branches further branched from the branches. Incidentally, at least 90% by number or more of the silver-coated copper powder thus obtained was a dendritic silver-coated copper powder having the shape described above.

In addition, the copper particles constituting the main stem and branches of the dendritic silver-coated copper powder had a flat plate shape having a cross sectional thickness of 3.4 µm on average, and the average particle diameter (D50) of the dendritic silver-coated copper powder was 58.9 µm. Moreover, the aspect ratio (cross sectional average thickness/average particle diameter) calculated from the cross sectional average thickness of the copper particles constituting the dendritic silver-coated copper powder and the average particle diameter of the dendritic silver-coated copper powder was 0.006. In addition, the bulk density of the copper powder thus obtained was 3.0 g/cm³. In addition, the BET specific surface area was 1.1 m²/g.

### <Formation into electrically conductive paste>

Next, the dendritic silver-coated copper powder fabricated by the method described above was formed into a paste to fabricate an electrically conductive paste.

In other words, 40 g of the dendritic silver-coated copper powder thus fabricated was mixed with 20 g of a phenol resin (PL-2211 manufactured by Gunei Chemical Industry Co., Ltd.) and 10 g of butyl cellosolve (KANTO CHEMICAL CO., INC. Cica Special Grade), and the mixture was repeatedly kneaded by using a small kneader (Non-bubbling Kneader NBK-1 manufactured by NIHONSEIKI KAISHA LTD.) for 3 minutes at 1500 rpm four times to be formed into a paste. Upon pasting, the copper powder was uniformly dispersed in the resin without aggregating. The electrically conductive paste thus obtained was printed on glass by using a metal squeegee and cured for 30 minutes at temperatures of 150°C and 200°C in the air atmosphere, respectively.

The specific resistance value of the coating film obtained by curing was measured, as a result, it was 16 × 10⁻⁶ Ω·cm (curing temperature: 150°C) and 2.3 × 10⁻⁶ Ω·cm (curing temperature: 200°C), respectively, and it was found that the electrically conductive paste exhibits excellent electrical conductivity.

### [Example 2]

### <Production of dendritic copper powder>

A solution having a composition in which the concentration of copper ion was 7 g/L and the concentration of sulfuric acid was 150 g/L was used as the electrolytic solution, Safranin 0 as an additive was added to the electrolytic solution so as to have a concentration of 150 mg/L in the electrolytic solution, and a hydrochloric acid solution was further added thereto so that the concentration of chlorine ion in the electrolytic solution was 25 mg/L. Thereafter, the temperature of the electrolytic solution adjusted to the concentration described above was maintained at 25°C while circulating the electrolytic solution at a flow rate of 15 L/min by using a metering pump, and an electric current was applied thereto so that the current density of the cathode was 20 A/dm², thereby precipitating a copper powder on the cathode plate. The electrolytic copper powder thus precipitated on the cathode plate was mechanically scraped off to the cell bottom of the electrolytic cell by using a scraper and recovered, and the copper powder thus recovered was washed with pure water, then placed in a vacuum dryer, and dried.

### <Fabrication of dendritic silver-coated copper powder by substitution method>

The surface of the copper powder was coated with silver by using 100 g of the dendritic copper powder thus obtained and a substitution type electroless plating solution.

As the substitution type electroless plating solution, a solution having a composition obtained by dissolving 20 g of silver nitrate, 20 g of citric acid, and 10 g of ethylenediamine in 1 liter of ion exchanged water was used, and 100 g of dendritic copper powder was added to the solution and reacted by being stirred for 60 minutes. The bath temperature at this time was 25°C.

After the reaction was completed, the powder was filtered, washed with water, and dried over ethanol, thereby obtaining a dendritic silver-coated copper powder in which the surface of the dendritic copper powder was coated with silver. In addition, the dendritic silver-coated copper powder had a flat plate shape constituted by one layer or a layered structure formed of a plurality of overlapping layers. The dendritic silver-coated copper powder was recovered, and the amount of silver coated was measured to have a result of 10.6% by mass with respect to 100% by mass of the entire silver-coated copper powder coated with silver. In addition, the dendritic silver-coated copper powder thus obtained was observed through an SEM in a field of vision at 5,000-times magnification, and as a result, a dendritic silver-coated copper powder in a state in which the surface of a dendritic copper powder before being coated with silver was uniformly coated with silver was formed, and the dendritic silver-coated copper powder was a silver-coated copper powder having a two-dimensional or three-dimensional dendritic shape having a dendritically grown main stem, a plurality of branches branched from the main stem, and branches further branched from the branches. Incidentally, at least 90% by number or more of the silver-coated copper powder thus obtained was a dendritic silver-coated copper powder having the shape described above.

In addition, the copper particles constituting the main stem and branches of the dendritic silver-coated copper powder had a flat plate shape having a cross sectional thickness of 1.2 µm on an average and a fine convex portion on the surface. In addition, the average particle diameter (D50) of this dendritic silver-coated copper powder was 44.6 µm. Moreover, the aspect ratio (cross sectional average thickness/average particle diameter) calculated from the cross sectional average thickness of the copper particles constituting the dendritic silver-coated copper powder and the average particle diameter of the dendritic silver-coated copper powder was 0.03. In addition, the bulk density of the copper powder thus obtained was 1.6 g/cm³. In addition, the BET specific surface area was 1.7 m²/g.

### <Formation into electrically conductive paste>

Next, the dendritic silver-coated copper powder thus fabricated was formed into a paste to fabricate an electrically conductive paste by the method described above.

In other words, 40 g of the dendritic silver-coated copper powder thus fabricated was mixed with 20 g of a phenol resin (PL-2211 manufactured by Gunei Chemical Industry Co., Ltd.) and 10 g of butyl cellosolve (KANTO CHEMICAL CO., INC. Cica Special Grade), and the mixture was repeatedly kneaded by using a small kneader (Non-bubbling Kneader NBK-1 manufactured by NIHONSEIKI KAISHA LTD.) for 3 minutes at 1500 rpm four times to be formed into a paste. Upon pasting, the copper powder was uniformly dispersed in the resin without aggregating. The electrically conductive paste thus obtained was printed on glass by using a metal squeegee and cured for 30 minutes at temperatures of 150°C and 200°C in the air atmosphere, respectively.

The specific resistance value of the coating film obtained by curing was measured, as a result, it was 28 × 10⁻⁶ Ω ·cm (curing temperature: 150°C) and 3.9 × 10⁻⁶ Ω·cm (curing temperature: 200°C), respectively, and it was found that the electrically conductive paste exhibits excellent electrical conductivity.

### [Example 3]

The dendritic silver-coated copper powder fabricated in Example 1 was dispersed in a resin to prepare an electromagnetic wave shielding material. Incidentally, the fabrication of dendritic copper powder for fabricating the dendritic silver-coated copper powder and the conditions until the dendritic silver-coated copper powder was fabricated by coating the dendritic copper powder with silver were the same as in Example 1, and a dendritic silver-coated copper powder having an amount of silver coated of 26.2% by mass with respect to 100% by mass of the entire silver-coated copper powder coated with silver was used.

With 40 g of this dendritic silver-coated copper powder, 100 g of a vinyl chloride resin and 200 g of methyl ethyl ketone were mixed, respectively, and the mixture was repeatedly kneaded by using a small kneader for 3 minutes at 1500 rpm four times to be formed into a paste. Upon pasting, the copper powder was uniformly dispersed in the resin without aggregating. This was applied on a substrate formed of a transparent polyethylene terephthalate sheet having a thickness of 100 µm by using a Mayer bar and dried to form an electromagnetic wave shielding layer having a thickness of 25 µm.

The electromagnetic wave shielding property was evaluated by measuring the attenuation factor by using an electromagnetic wave having a frequency of 1 GHz. The results thereof are presented in Table 1.

### [Comparative Example 1]

A copper powder was precipitated on the cathode plate in the same manner as in Example 1 except that Safranin 0 as an additive and chlorine ion were not added to the electrolytic solution. Then, the surface of the copper powder thus obtained was coated with silver in the same manner as in Example 1 to obtain a silver-coated copper powder. Incidentally, the amount of silver coated on the silver-coated copper powder was 26.1% by mass with respect to 100% by mass of the entire silver-coated copper powder coated with silver.

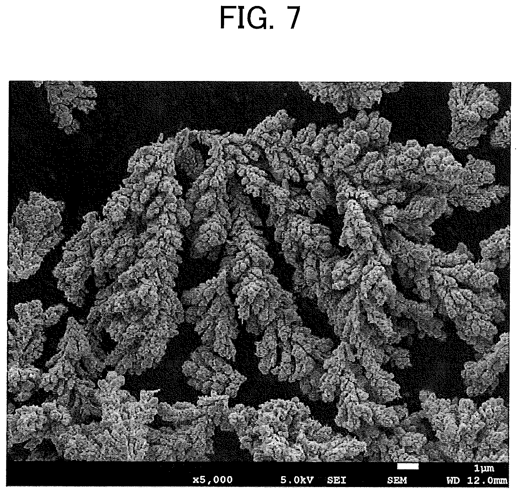

The results obtained by observing the shape of the silver-coated copper powder thus obtained through an SEM in a field of vision at 5,000-times magnification is illustrated in Fig. 7. As illustrated in the photograph of Fig. 7, the shape of the silver-coated copper powder thus obtained was a dendritic shape formed as particulate copper gathered, it was in a state in which the surface of the copper powder was coated with silver, and the average particle diameter (D50) of the silver-coated copper powder was 45.3 µm. In addition, a fine convex portion was not formed on the dendritic portion.

20 g of a phenol resin (PL-2211 manufactured by Gunei Chemical Industry Co., Ltd.) and 10 g of butyl cellosolve (KANTO CHEMICAL CO., INC. Cica Special Grade) were mixed with 40 g of the silver-coated copper powder fabricated by the method described above, and the mixture was repeatedly kneaded by using a small kneader (Non-bubbling Kneader NBK-1 manufactured by NIHONSEIKI KAISHA LTD.) for 3 minutes at 1500 rpm four times to be formed into a paste. Upon pasting, an increase in viscosity occurred whenever kneading was repeated. This was considered to be caused by aggregation of a part of the copper powder, and it was difficult to uniformly disperse the copper powder. The electrically conductive paste thus obtained was printed on glass by using a metal squeegee and cured for 30 minutes at temperatures of 150°C and 200°C in the air atmosphere, respectively.

The specific resistance value of the coating film obtained by curing was measured, as a result, it was 670 × 10⁻⁶ Ω·cm (curing temperature: 150°C) and 310 × 10⁻⁶ Ω·cm (curing temperature: 200°C), respectively, and the electrically conductive paste thus obtained had an high specific resistance value and exhibited poorer electrical conductivity as compared to the electrically conductive pastes obtained in Examples.

### [Comparative Example 2]

### <Production of dendritic copper powder>

A solution having a composition in which the concentration of copper ion was 10 g/L and the concentration of sulfuric acid was 150 g/L was used as the electrolytic solution. In addition, Safranin 0 (manufactured by Kanto Chemical Industry Co., Ltd.) as an additive was added to the electrolytic solution so as to have a concentration of 50 mg/L in the electrolytic solution, and a hydrochloric acid solution (manufactured by Wako Pure Chemical Industries, Ltd.) was further added thereto so that the concentration of chloride ion (chlorine ion) in the electrolytic solution was 10 mg/L. Thereafter, an electric current was applied to the electrolytic solution having a concentration adjusted as described above so that the current density of the cathode was 20 A/dm² while circulating the electrolytic solution at a flow rate of 15 L/min by using a metering pump and the temperature of the electrolytic solution was maintained at 45°C, thereby precipitating a copper powder on the cathode plate.

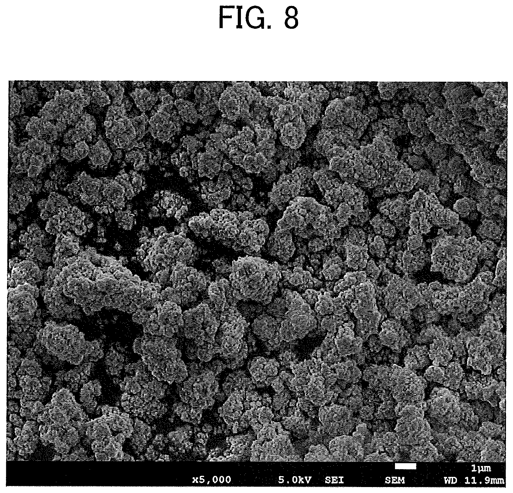

The results obtained by observing the shape of the silver-coated copper powder thus obtained through an SEM in a field of vision at 5,000-times magnification are illustrated in Fig. 8. As illustrated in the photograph of Fig. 8, the shape of the electrolytic copper powder thus obtained was a dendritic copper powder formed as copper particles having a granular shape gathered. However, the dendritic main stem and branch were rounded but did not have a flat plate shape constituted by one layer or a plurality of overlapping multilayer structures as the copper powder obtained in Examples.

### <Production of dendritic silver-coated copper powder by reduction method>

Next, a silver-coated copper powder was fabricated in the same manner as in Example 1 by using the dendritic copper powder thus obtained.

The dendritic silver-coated copper powder thus obtained was recovered, and the amount of silver coated was measured, and as a result, it was 26.5% by mass with respect to 100% by mass of the entire silver-coated copper powder coated with silver. In addition, the dendritic silver-coated copper powder thus obtained was observed through a SEM in a field of vision at 5,000-times magnification, and as a result, the dendritic silver-coated copper powder was a dendritic silver-coated copper powder which had a two-dimensional or three-dimensional dendritic shape and in which the surface of the dendritic copper powder before being coated with silver was uniformly coated with silver and the dendritic silver-coated copper powder did not have a flat plate shape constituted by one layer or a layered structure formed of a plurality of overlapping layers as the silver-coated copper powders obtained in Examples.

### <Formation into electrically conductive paste>

Next, the dendritic silver-coated copper powder fabricated by the method described above was formed into a paste to fabricate an electrically conductive paste.

In other words, with 40 g of the dendritic silver-coated copper powder fabricated by the method described above, 20 g of a phenol resin (PL-2211 manufactured by Gunei Chemical Industry Co., Ltd.) and 10 g of butyl cellosolve (KANTO CHEMICAL CO., INC. Cica Special Grade) were mixed, and the mixture was repeatedly kneaded by using a small kneader (Non-bubbling Kneader NBK-1 manufactured by NIHONSEIKI KAISHA LTD.) for 3 minutes at 1500 rpm four times to be formed into a paste. Upon pasting, the copper powder was uniformly dispersed in the resin without aggregating with one another. The electrically conductive paste thus obtained was printed on glass by using a metal squeegee and cured for 30 minutes at temperatures of 150°C and 200°C in the air atmosphere, respectively.

The specific resistance value of the coating film obtained by curing was measured, and as a result, it was 530 × 10⁻⁶ Ω·cm (curing temperature: 150°C) and 360 × 10⁻⁶ Ω·cm (curing temperature: 200°C), respectively.

### [Comparative Example 3]

The properties of the electrically conductive paste with a silver-coated copper powder obtained by coating a flat plate-shaped copper powder of the prior art with silver were evaluated and compared to the properties of the electrically conductive pastes fabricated by using the dendritic silver-coated copper powders of Examples.

The flat plate-shaped copper powder was fabricated by mechanically flattening a granular electrolytic copper powder. Specifically, 5 g of stearic acid was added to 500 g of a granular atomized copper powder (manufactured by MAKIN METAL POWDERS LTD.) having an average particle diameter of 7.9 µm, and the mixture was subjected to flattening treatment by a ball mill. The flattening treatment was conducted by putting 5 kg of 3 mm zirconia beads in the ball mill and rotating the mixture for 60 minutes at a rotation speed of 500 rpm.

The flat plate-shaped copper powder thus obtained was coated with silver by the same method as in Example 1. The amount of silver coated on the silver-coated copper powder thus fabricated was 26.4% by mass with respect to 100% by mass of the entire flat plate-shaped silver-coated copper powder coated with silver. The flat plate-shaped silver-coated copper powder thus fabricated was subjected to the measurement using a particle size distribution measuring instrument by a laser diffraction/scattering method and, as a result, the average particle diameter (D50) thereof was 24.1 µm, and the copper powder was subjected to the measurement using a SEM and, as a result, the thickness thereof was 0.6 µm and a smooth and fine convex portion was not formed on the surface. Moreover, the aspect ratio (cross sectional average thickness/average particle diameter) calculated from the cross sectional average thickness and the average particle diameter was 0.02.

Next, 20 g of a phenol resin (PL-2211 manufactured by Gunei Chemical Industry Co., Ltd.) and 10 g of butyl cellosolve (KANTO CHEMICAL CO., INC. Cica Special Grade) were mixed with 40 g of the flat plate-shaped silver-coated copper powder thus obtained, and the mixture was repeatedly kneaded by using a small kneader (Non-bubbling Kneader NBK-1 manufactured by NIHONSEIKI KAISHA LTD.) for 3 minutes at 1500 rpm four times to be formed into a paste. Upon pasting, the copper powder was uniformly dispersed in the resin without aggregating with one another. The electrically conductive paste thus obtained was printed on glass by using a metal squeegee and cured for 30 minutes at temperatures of 150°C and 200°C in the air atmosphere, respectively.

The specific resistance value of the coating film obtained by curing was measured, and as a result, it was 59 × 10⁻⁶ Ω·cm (curing temperature: 150°C) and 10 × 10⁻⁶ Ω·cm (curing temperature: 200°C), respectively, and the electrically conductive paste thus obtained had a higher specific resistance value and exhibited poorer electrical conductivity as compared to the electrically conductive pastes obtained in Examples 1 and 2.

### [Comparative Example 4]

A silver-coated copper powder in which a flat plate-shaped copper powder fabricated by mechanically flattening a granular electrolytic copper powder was coated with silver was fabricated in the same manner as that used in Comparative Example 3, and the properties of the electromagnetic wave shield from the silver-coated copper powder were evaluated and compared to the properties of the electromagnetic wave shield fabricated by using the dendritic silver-coated copper powder of Example to examine the effect of dendritic shape. Incidentally, the flat plate-shaped silver-coated copper powder used was coated with silver by the same method as in Example 1. The amount of silver coated on the silver-coated copper powder thus fabricated was 26.1% by mass with respect to 100% by mass of the entire flat plate-shaped silver-coated copper powder coated with silver.

100 g of a vinyl chloride resin and 200 g of methyl ethyl ketone were mixed with 40 g of this flat plate-shaped silver-coated copper powder, respectively, and the mixture was repeatedly kneaded by using a small kneader for 3 minutes at 1500 rpm four times to be formed into a paste. Upon pasting, the copper powder was uniformly dispersed in the resin without aggregating. This was applied on a substrate formed of a transparent polyethylene terephthalate sheet having a thickness of 100 µm by using a Mayer bar and dried to form an electromagnetic wave shielding layer having a thickness of 25 µm.

The electromagnetic wave shielding property was evaluated by measuring the attenuation factor by using an electromagnetic wave having a frequency of 1 GHz. The results thereof are presented in Table 1.

**[Table 1]**

| | Shape | | | Properties of electrically conductive paste (× 10⁻⁶Ωcm) | | Properties of electromagnetic wave shield | |
|---|---|---|---|---|---|---|---|
| | Cross sectional average thickness [µm] | Average particle diameter [µm] | Aspect ratio [Cross sectional average thickness /average particle diameter] | 150°C | 200°C | Plane | Bending |
| Example 1 | 3.4 | 58.9 | 0.006 | 16 | 2.3 | - | - |
| Example 2 | 1.2 | 44.6 | 0.03 | 28 | 3.9 | - | - |
| Example 3 | 3.4 | 58.9 | 0.006 | - | - | ⊙ | ○ |
| Comparative Example 1 | - | 45.3 | - | 670 | 310 | - | - |
| Comparative Example 2 | - | 6.7 | - | 530 | 360 | - | - |
| Comparative Example 3 | 0.6 | 24.1 | 0.02 | 59 | 10 | - | - |
| Comparative Example 4 | 0.6 | 24.1 | 0.02 | - | - | Δ | × |

### EXPLANATION OF REFERENCE NUMERALS

1 Copper powder
2 Main stem (of copper particle)
3, 3a, 3b Branch (of copper particle)

## Claims

1. A silver-coated copper powder formed as copper particles having a dendritic shape having a linearly grown main stem and a plurality of branches separated from the main stem gather, wherein
a surface of the silver-coated copper powder is coated with silver,
the silver-coated copper powder has a flat plate shape having a cross sectional average thickness of the main stem and the branches of the copper particles of more than 1.0 µm and 5.0 µm or less,
the silver-coated copper powder has a flat plate shape constituted by one layer or a layered structure formed of a plurality of overlapping layers and an average particle diameter (D50) is from 1.0 µm to 100 µm.

2. The silver-coated copper powder according to claim 1, wherein a ratio obtained by dividing a cross sectional average thickness of the copper particles coated with silver by an average particle diameter (D50) of the silver-coated copper powder is in a range of more than 0.01 and 5.0 or less.

3. The silver-coated copper powder according to claim 1 or 2, wherein an amount of silver coated is from 1% by mass to 50% by mass with respect to 100% by mass of the entire silver-coated copper powder coated with silver.

4. The silver-coated copper powder according to any one of claims 1 to 3, wherein a bulk density of the silver-coated copper powder is in a range of from 0.5 g/cm³ to 5.0 g/cm³.

5. The dendritic silver-coated copper powder according to any one of claims 1 to 4, wherein a BET specific surface area value is from 0.2 m²/g to 3.0 m²/g.

6. A metal filler comprising the silver-coated copper powder according to any one of claims 1 to 5 at a proportion of 20% by mass or more to the entire metal filler.

7. An electrically conductive paste comprising the metal filler according to claim 6 mixed with a resin.

8. An electrically conductive coating material for electromagnetic wave shielding comprising the metal filler according to claim 6.

9. An electrically conductive sheet for electromagnetic wave shielding comprising the metal filler according to claim 6.
